# EUROPEAN PATENT APPLICATION

(11) **EP 3 885 310 A1**
(43) Date of publication of application: **29.09.2021**
(21) Application number: 19887294.7
(22) Date of filing: 11.11.2019
(51) Int. Cl.: B81B 1/00, G01N 37/00, G01N 35/08, B01J 19/00

(54) **LIQUID MANIPULATION DEVICE**

(30) Priority: 20.11.2018 JP 2018217609
(71) Applicant: NATIONAL INSTITUTE OF ADVANCED INDUSTRIAL SCIENCE AND TECHNOLOGY, Chiyoda-ku Tokyo 100-8921 (JP)
(72) Inventor: MOGI, Katsuo, Tokyo 135-0064 (JP); ADACHI, Shungo, Tokyo 135-0064 (JP); INOUE, Tomoya, Tsukuba-shi, Ibaraki 305-8560 (JP); NATSUME, Tohru, Tokyo 135-0064 (JP)
(74) Representative: HGF
(86) International application number: PCT/JP2019/044114
(87) International publication number: WO 2020/105488

(57) **Abstract**

A liquid manipulation device has an enhanced ability to control liquid, in particular, a droplet, and offers improved fabrication efficiency. The liquid manipulation device according to the present invention includes: a substrate 1, 11 including a sheet shape or a film shape to have flexibility; a plurality of electrodes 2 located on a front surface 1b, 11b of the substrate 1, 11; and an insulating layer located over the front surface 1b, 11b of the substrate 1, 11 to cover the electrodes 2. The liquid manipulation device is configured to move liquid L on a front surface 3b of the insulating layer 3 by using an electrostatic force that is generated when voltage is applied to at least one of the electrodes 2. In the liquid manipulation device, the insulating layer 3 includes dimples 4 that are located in correspondence with the electrodes 2 and are curved concave in a concave direction directed from the front surface 3b of the insulating layer 3 toward the back surface 3a of the insulating layer 3. Each of the electrodes 2 includes a dimple-corresponding portion 5 being curved concave in the concave direction together with one of the dimples 4 that is located in correspondence with the corresponding electrode 2.

## Description

### [Technical Field]

The present invention relates to a liquid manipulation device configured to move liquid using electrostatic force.

### [Background Art]

Various technological fields, such as biotechnology, medicine, drug development, microelectromechanical systems (MEMS), and/or the like are focusing increasing attention on EWOD (Electro Wetting On Dielectric). Based on EWOD, liquids, in particular, droplets, are manipulated using electrostatic force. In particular, in the technological fields of biotechnology, medicine, drug development, and/or the like, EWOD has a great potential for handling rare reagents, dangerous agents, and/or the like.

Typically, a device based on EWOD (hereinafter referred to as "liquid manipulation device") includes: a substrate having electrodes; and an insulating layer having a back surface and a front surface. The back surface of the insulating layer is located on and bonded to a front surface of the substrate. The front surface of the insulating layer is opposite the back surface of the insulating layer and has a reduced frictional resistance. The device changes an electrostatic force based on the application of voltage to the electrodes to thereby enable a droplet to slide over the front surface of the insulating layer. (For example, see Non-Patent Document 1.) To stop a droplet at a desired position on the front surface of the insulating layer with the reduced frictional resistance in the liquid manipulation device, it is important to appropriately adjust environmental conditions, such as strength of the electrostatic force, the hydrophobicity of the insulating layer, the frictional resistance, and/or the like.

However, it is difficult to appropriately adjust such environmental conditions, and the liquid manipulation devices have low capabilities to control droplets. This is a factor that hinders widespread application of EWOD. To enhance the capability to control droplets, various liquid manipulation devices have been proposed.

For example, a liquid manipulation device proposed therein, includes: a substrate having first electrodes; a first insulating layer having a back surface and a front surface, the back surface of the first insulating layer being located on and bonded to a front surface of the substrate, the front surface of the first insulating layer being opposite the back surface of the first insulating layer and having a reduced frictional resistance; a second insulating layer spaced from the front surface of the first insulating layer and having a front surface with a reduced frictional resistance; and a second electrode located opposite the first insulating layer with respect to the second insulating layer. The liquid manipulation device is configured to change an electrostatic force based on the application of voltage to the first and second electrodes to thereby enable a droplet to move in a space between the first and second insulating layers along the front surfaces of the first and second insulating layers.

In a more specific example, a liquid manipulation device, cited as an example thereof, includes: a first insulating layer; and an adhesive layer that is made of an adhesive and located between the first insulating layer and a substrate. The first insulating layer and the adhesive layer have recess portions that are located so as to correspond to first electrodes and recessed from a surface of the first insulating layer. A surface of the substrate and surfaces of the first electrodes, which are located along the surface of the substrate, are flat. To form the recess portions of this liquid manipulation device, a mold having protrusion portions corresponding to the recess portions, is pressed onto the surface of the first insulating layer under predefined heating temperature and pressure for a predefined pressing time so as to deform the first insulating layer and the adhesive layer only. (For example, see Patent Document 1.)

In a liquid manipulation device cited as another example thereof, a first insulating layer is bent to have concave portions that are concave in a surface of the first insulating layer, and a substrate has through holes located in correspondence with the concave portions of the first insulating layer. (For example, see Patent Document 2.)

In a liquid manipulation device cited as still another example thereof, a second insulating layer has concave portions and convex portions in a surface. The convex portions are located in correspondence with first electrodes. When voltage is applied to a first electrode, a droplet is stopped at a convex portion corresponding to the first electrode. (For example, see Patent Document 3.)

### [Citation List]

### [Patent Document]

[Patent Document 1] US 2012/261264 A
[Patent Document 2] JP 2007-212943 A
[Patent Document 3] WO 2008/007511 A

### [Non-Patent Document]

[Non-Patent Document 1] Hyojin Ko and seven others, "Active Digital Microfluidic Paper Chips with Inkjet-Printed Patterned Electrodes," ADVANCED MATERIALS, Volume 26, Issue 15, April 16, 2014, pp. 2335 to 2340

### [Summary of Invention]

### [Technical Problem]

In the example of the liquid manipulation device described above, processing conditions, such as heating temperature, pressure, pressing time, and the like are set such that only the first insulating layer and the adhesive layer are deformed when the recess portions are formed in the first insulating layer. However, it is difficult to set such processing conditions appropriately. Another example of the liquid manipulation device requires forming the holes in the substrate when the concave portions are provided in the first insulating layer. The task of forming such holes in the substrate, reduces the efficiency for fabricating the liquid manipulation device. Still another example of the liquid manipulation device cannot stop a droplet at a position corresponding to the first electrode efficiently because the droplet is apt to move from a convex portion to a concave portion. Thus, the device has a reduced ability to control droplets.

In view of the circumstances described above, it is desired that a liquid manipulation device have an enhanced ability to control liquid, in particular, droplets, and offer improved fabrication efficiency.

### [Solution to Problem]

To provide a solution to the problems described above, a liquid manipulation device according to an aspect includes: a substrate including a sheet shape or a film shape to have flexibility; a plurality of electrodes located on a front surface of the substrate; and an insulating layer located over the front surface of the substrate to cover the electrodes, the insulating layer has: a back surface facing the front surface of the substrate; and a front surface of the insulating layer being located opposite the back surface of the insulating layer with respect to a thickness direction of the insulating layer, the liquid manipulation device is configured to move liquid on the front surface of the insulating layer by using an electrostatic force that is generated when voltage is applied to at least one of the electrodes, the insulating layer includes dimples that are located in correspondence with the electrodes respectively and are curved concave in a concave direction directed from the front surface of the insulating layer toward the back surface of the insulating layer, and each of the electrodes includes a dimple-corresponding portion being curved concave in the concave direction together with one of the dimples that is located in correspondence with the corresponding electrode.

### [Advantageous Effects of Invention]

A liquid manipulation device according to an aspect can have an enhanced capability to control liquid, in particular, droplets, and offer improved fabrication efficiency.

### [Brief Description of Drawings]

[Fig. 1] Fig. 1 is a plan view schematically showing a liquid manipulation device according to a First Embodiment.
[Fig. 2] Fig. 2 is a sectional view taken along line A-A of Fig. 1.
[Fig. 3] Figs. 3(a), (b), and (c) are sectional views schematically showing the liquid manipulation devices taken along line B-B of Fig. 1, in a state before a droplet is moved, a state during the movement of the droplet, and a state after the droplet is moved, respectively.
[Fig. 4] Figs. 4(a), (b), and (c) are sectional views schematically showing the liquid manipulation devices taken along line A-A of Fig. 1, in a state before a dimple forming process, a state during the dimple forming process, and a state after the dimple forming process, respectively.
[Fig. 5] Fig. 5 is a sectional view schematically showing a liquid manipulation device according to a Second Embodiment, taken along a line corresponding to the line A-A of Fig. 1.

### [Description of Embodiments]

Liquid manipulation devices according to First and Second Embodiments are described below.

As described herein, a "film" indicates an object having a layer shape and having a thickness of approximately 200 µm (micrometer) or less, and a "sheet" indicates an object having a layer shape and having a thickness exceeding approximately 200 µm.

### "First Embodiment"

A liquid manipulation device according to a First Embodiment is described below.

### "Outline of liquid manipulation device"

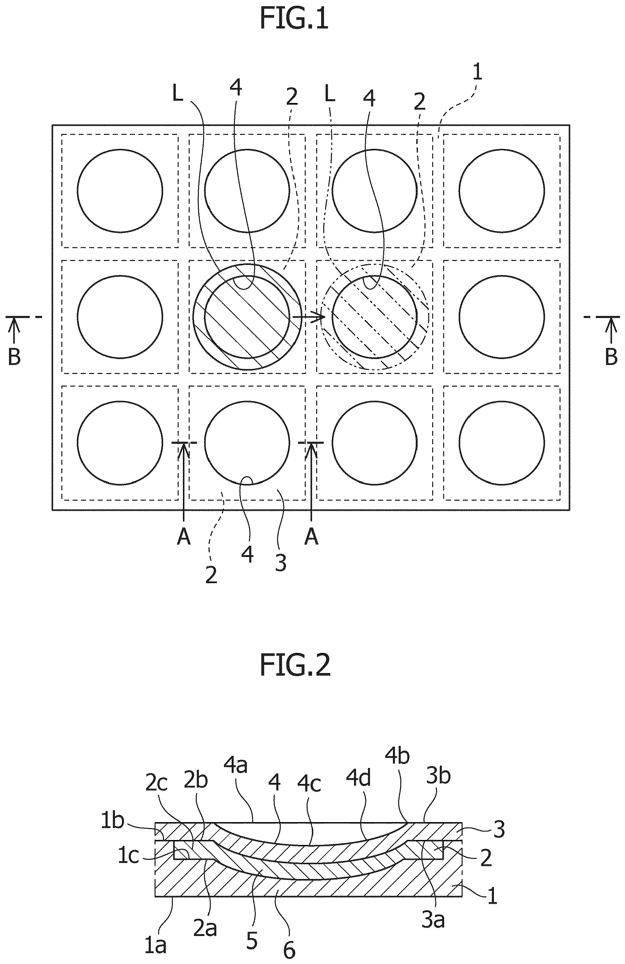

The liquid manipulation device according to the present Embodiment is described in outline with reference to Figs. 1 and 2. The liquid manipulation device includes a substrate 1 having a sheet shape or a film shape so as to have flexibility. The substrate 1 has a back surface 1a, and a front surface 1b located opposite the back surface 1a with respect to a thickness direction of the substrate 1.

The liquid manipulation device includes electrodes 2 located on the front surface 1b of the substrate 1. The liquid manipulation device includes an insulating layer 3 located over the front surface 1b of the substrate 1 so as to cover the electrodes 2. The liquid manipulation device is configured to move liquid L, in particular, a droplet L, on a front surface 3b of the insulating layer 3 by using an electrostatic force that is generated when voltage is applied to at least one of the electrodes 2. The front surface 3b of the insulating layer 3 is described below.

The insulating layer 3 of the liquid manipulation device has a back surface 3a and the front surface 3b. The back surface 3a of the insulating layer 3 faces the front surface 1b of the substrate 1. The front surface 3b of the insulating layer 3 is located opposite the back surface 3a of the insulating layer 3 with respect to a thickness direction of the insulating layer 3. The insulating layer 3 includes dimples 4 that are curved concave in a concave direction directed from the front surface 3b of the insulating layer 3 toward the back surface 3a of the insulating layer 3. The dimples 4 are located in correspondence with the electrodes 2 respectively. Each of the electrodes 2 includes a first dimple-corresponding portion 5 being curved concave in the concave direction together with one of the dimples 4 that is located in correspondence with the corresponding electrode 2.

Furthermore, the front surface 3b of the insulating layer 3 may be open to the outside. Each of the electrodes 2 may be larger than the corresponding one of the dimples 4.

### "Details of substrate"

The substrate 1 is described below in detail with reference to Figs. 1 and 2. The substrate 1 may be configured as described below. In Fig. 2, the substrate 1 includes concave portions 1c that are concave in correspondence with the electrodes 2 respectively. The substrate 1 also includes second dimple-corresponding portions 6 that are concave in the concave direction in correspondence with the first dimple-corresponding portions 5 of the electrodes 2 respectively. The second dimple-corresponding portion 6 is located within the concave portion 1c. The back surface 1a of the substrate 1 is smooth or flat. Alternatively, the substrate can be formed to include the second dimple-corresponding portions and include no concave portions. In that case, the electrodes may be placed on the substrate using, for example, a printer, such as an ink jet printer or the like.

The substrate 1 may be made using paper, resin, and/or the like. As used herein, "paper" indicates a material fabricated by aggregating plant fibers, other fibers, and/or the like, and may include: an inorganic substance, such as a porous material and/or the like; and organic molecules, such as synthetic molecules added to it, and/or the like; and/or the like. As used herein, "resin" indicates a material including a natural and/or synthetic macromolecular compound as the principal component. The material may be a composite material that further includes fiber, an inorganic substance, and/or the like. In particular, thermoplastic resin which can be processed with heat easily, may be used. In particular, the substrate 1 may be bendable. The substrate 1 may also be cuttable using a cutting tool, such as scissors, a cutter, and/or the like.

The thickness of the substrate 1 is set such that the substrate 1 possesses flexibility. For example, when the substrate 1 is made using paper or is of paper, the substrate 1 can have a thickness of approximately 100 µm to approximately 200 µm. When the substrate 1 is made using or of resin, the substrate 1 may be a film having a thickness of approximately 200 µm or less. Alternatively, the substrate 1 made using or of resin, may be a sheet having a thickness exceeding approximately 200 µm. It is preferable that the substrate 1 not be made using glass or silicon. However, these are not limitations to the material and thickness of the substrate of the present invention. The thickness of the substrate 1 can be set such that the substrate 1 has flexibility and the back surface 1a of the substrate 1 remains smooth or flat at locations at which the second dimple-corresponding portions 6 are located even after the dimple forming process is performed to form the dimples 4 as described below.

### "Details of electrode"

The electrodes 2 are described below in detail with reference to Figs. 1, 2, and 3(a) to 3(c). The electrode 2 may be configured as described below. The electrode 2 is made of a conductive material. The conductive material may be a material, such as metal, carbon, metallic oxide, a material containing at least one material among the materials set forth, or the like. The electrode 2 has a layer shape. The electrode can be formed using, for example, a conductive ink. The thickness of the electrode 2 is set to allow plastic deformation of the electrode 2 and the insulating layer 3 together during the dimple forming process, which will be described below.

The electrode 2 has a back surface 2a and a front surface 2b. The back surface 2a of the electrode 2 faces the front surface 1b of the substrate 1. The front surface 2b of the electrode 2 is located opposite the back surface 2a of the electrode 2 with respect to a thickness direction of the electrode 2. The electrode 2 also includes a perimeter portion 2c located on the outer periphery of the first dimple-corresponding portion 5. The perimeter portion 2c is located along the front surface 1b of the substrate 1.

In Fig. 2, the electrode 2 is located within the concave portion 1c of the substrate 1 with the front surface 2b of the electrode 2 substantially coincident with the front surface 1b of the substrate 1. If the substrate is formed to include the second dimple-corresponding portions and include no concave portions as described above, the perimeter portions of the electrodes can be located on the front surface of the substrate to protrude from the front surface of the substrate.

The electrodes 2 are spaced apart from one another on the front surface 1b of the substrate 1. Furthermore, the electrodes 2 are arranged into a matrix with m rows and n columns on the front surface 1b of the substrate 1. As used herein, m is an integer of 1 or greater, and n is an integer of 2 or greater. Alternatively, m is an integer of 2 or greater and n is an integer of 1 or greater. In an example in Fig. 1, 12 electrodes 4 are arranged into a matrix with three rows and four columns. The arrangement of the electrodes is not limited to a matrix. The electrodes may be located such that a desired movement route intended for liquid can be provided. For example, the electrodes can be arranged into a honeycomb matrix in which the shapes of the electrodes are not limited to substantially hexagonal shapes.

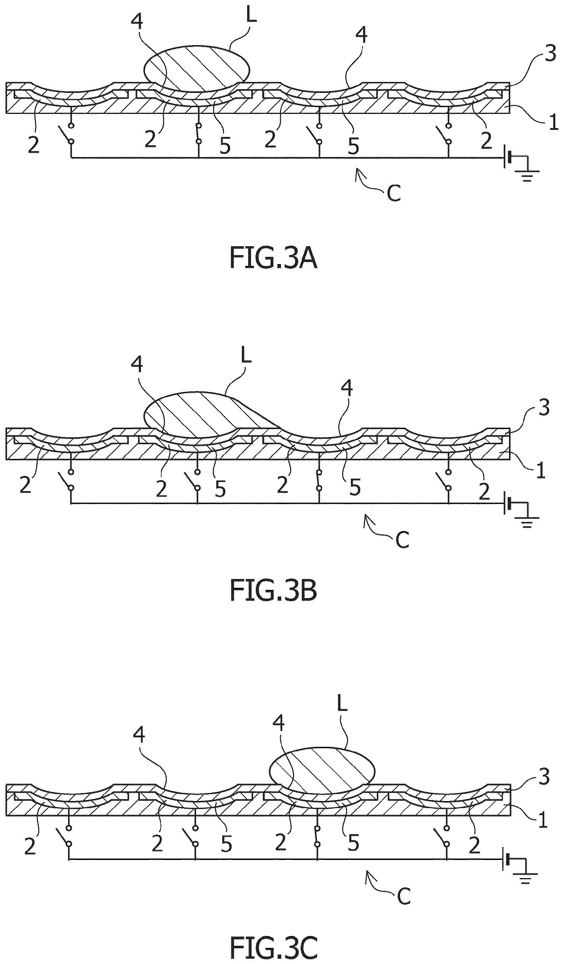

As shown in Figs. 3(a) to 3(c), the electrodes 2 are connected to a circuit C. The circuit C is configured to apply voltage to the electrodes 2 individually. In Fig. 1, the circuit C is located outside the substrate 1. However, this is not a limitation to the present invention. At least a portion of the circuit may be located in the substrate. For example, wiring of the circuit, which is a portion of the circuit, may be located in the substrate.

In Figs. 3(a) to 3(c), the circuit C including a switch, a power supply, and grounding, is schematically shown as an example to describe states in which voltage is applied to the electrodes 2 individually. The circuit connected to the electrodes, is not limited to the circuit C shown in Figs. 3(a) to 3(c). The circuit can have any configuration as long as voltage can be applied to the electrodes individually to generate an electrostatic force for stopping and moving a droplet.

### "Details of insulating layer"

The insulating layer 3 is described below in detail with reference to Figs. 1 and 2. The insulating layer 3 may be configured as described below. The insulating layer 3 may be electrically insulating. The insulating layer 3, in particular, the front surface 3b of the insulating layer 3, may be hydrophobic. The insulating layer 3 may thus be made using an electrically insulating and hydrophobic material. The material may be an electrically insulating and hydrophobic resin, for example, fluororesin or the like. The front surface of the insulating layer can be made using a hydrophobic material or an electrically insulating and hydrophobic material, and the remaining portion of the insulating layer can be made using an electrically insulating material.

Each of the dimples 4 of the insulating layer 3 includes an opening portion 4a and an opening edge portion 4b. The opening portion 4a is open in the front surface 3b of the insulating layer 3. The opening edge portion 4b is located at the edge of the opening portion 4a, surrounding the opening portion 4a. The opening edge portion 4b has a substantially circular shape. However, the shape of the opening edge portion is not limited to a substantially circular shape. For example, the opening edge portion can have: a substantially polygonal shape, such as a substantially rectangular shape, a substantially hexagonal shape, or the like; a substantially elliptical shape; or the like. The opening edge portion can have a curved corner.

The dimple 4 also includes a bottom portion 4c facing the opening portion 4a in the thickness direction of the insulating layer 3 and being located toward the back surface 3a of the insulating layer 3 with respect to the opening portion 4a. The dimple 4 also includes a surrounding wall portion 4d extending between the opening edge portion 4b and the bottom portion 4c. The bottom portion 4c has a substantially arc shape that is concave in the concave direction. However, the shape of the bottom portion is not limited to a substantially arc shape. For example, the bottom portion can have a substantially flat shape. The bottom portion can have a substantially conic shape that is concave in the concave direction.

The surrounding wall portion 4d becomes narrower toward the bottom portion 4c from the opening edge portion 4b. The surrounding wall portion 4d has a substantially arc shape that is concave in the concave direction. However, the shape of the surrounding edge portion is not limited to a substantially arc shape. For example, the surrounding wall portion can extend substantially straight between the opening edge portion and the bottom portion.

The bottom portion 4c and the surrounding wall portion 4d of the dimple 4 that have substantially arc shapes concave in the concave direction, have curvatures that are substantially the same. Alternatively, the bottom portion and the surrounding wall portion that have substantially arc shapes, can have different curvatures. Furthermore, the maximum depth of the dimple 4, the size of the opening edge portion 4b of the dimple 4, the shape of the dimple 4, and the like are defined such that the liquid L, in particular, the droplet L, can be retained continuously and stably in a position in which the dimple 4 is located and the liquid L, in particular, the droplet L, fitted in the dimple 4, can be moved smoothly.

### "Manipulation to move liquid"

With reference to Figs. 1 and 3(a) to 3(c), manipulation to move the droplet L in the liquid manipulation device according to the present Embodiment is described below. As shown in Figs. 1 and 3(a), the droplet manipulation device is in a first voltage application state in which a voltage is applied to one of the electrodes 2, and a voltage lower than the voltage applied to the one of the electrodes 2 or no voltage, is applied to the remaining electrodes 2 or electrodes 2 located in the vicinity of the one of the electrodes 2. Due to an electrostatic force generated in the first voltage application state, and fitting of a droplet L in one of the dimples 4 that corresponds to the one of the electrodes 2, the droplet L is retained continuously and stably in a first stop position in which the one of the dimples 4 is located.

As shown in Fig. 3(b), the droplet manipulation device is then in a second voltage application state in which a voltage is applied to another one of the electrodes 2 located next to the one of the electrodes 2, and a voltage lower than the voltage applied to the other one of the electrodes 2 or no voltage is applied to the remaining electrodes 2 or electrodes 2 located in the vicinity of the other one of the electrodes 2. Due to an electrostatic force generated in the second voltage application state, the droplet L located in the first stop position, is attracted to a second stop position in which another one of the dimples 4 that corresponds to the other one of the electrodes is located. The droplet L moves from the first stop position to the second stop position.

As shown in Figs. 1 and 3(c), due to the electrostatic force generated in the second voltage application state and fitting of the droplet L in the other one of the dimples 4, the droplet L is then stopped at the second stop position reliably and retained in the second stop position continuously and stably. In particular, the droplet L moving from the first stop position to the second stop position, can be stopped at the second stop position reliably by the other one of the dimples 4, countering the inertial force of the droplet L. In Fig. 1, the droplet L is indicated by an imaginary line, which is a two-dot chain line.

### "Method of forming dimple"

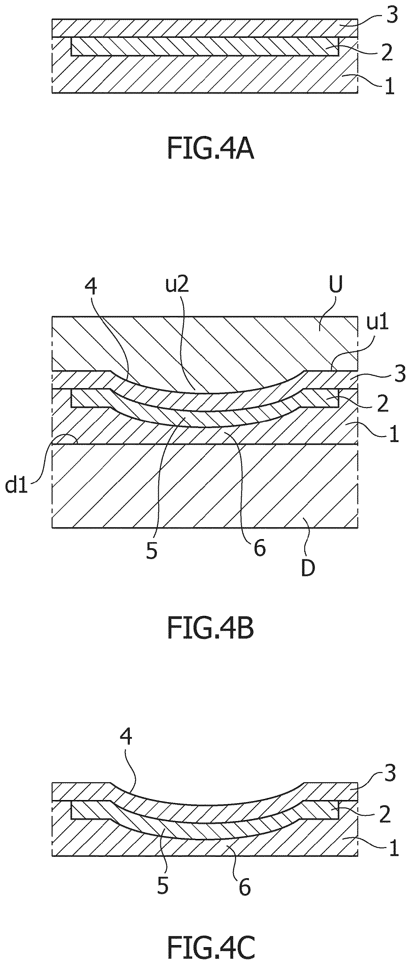

With reference to Figs. 4(a) to 4(c), a method of forming the dimple 4 in the liquid manipulation device according to the present Embodiment, is described below. As shown in Fig. 4(a), in the liquid manipulation device in which the dimple 4 is to be formed, the electrode 2 is placed on the substrate 1, and the insulating layer 3 is placed over the substrate 1 so as to cover the electrode 2, while the insulating layer 3, the electrode 2, and the substrate 1 are substantially flat.

As shown in Fig. 4(b), a process (hereinafter referred to as dimple forming process as required) is then performed on the liquid manipulation device in which the dimple 4 is to be formed. In the process, a lower mold D is brought into contact with the back surface 1a of the substrate 1, and an upper mold U is pressed onto the front surface 3b of the insulating layer 3 with a predefined pressing pressure for a predefined pressing time. In the dimple forming process, the lower mold D has a contact surface d1 that is brought into contact with the back surface 1a of the substrate 1. The contact surface d1 of the lower mold D is substantially flat. The upper mold U has a contact surface u1 that is brought into contact with the front surface 3b of the insulating layer 3. The contact surface u1 of the upper mold U includes convex portions u2 that correspond to the dimples 4 respectively. The process may be performed with the upper mold U heated to a predefined heating temperature. The pressing pressure, pressing time, and heating temperature of the dimple forming process may be adjusted such that the dimples 4 of the insulating layer 3 and the dimple-corresponding portions 5 of the electrodes 2 can be plastically formed appropriately. The dimple forming process may be an embossing process, but this is not a limitation.

As shown in Fig. 4(c), when the upper mold U and the lower mold D are separated from the liquid manipulation device after the elapse of the predefined pressing time, the dimple 4 of the insulating layer 3 is curved concave in the concave direction. The dimple-corresponding portion 5 of the electrode 2, is also curved concave in the concave direction together with the dimple 4 that is located in correspondence with the electrode 2. The back surface 1a of the substrate 1 remains smooth or flat.

As described above, in the liquid manipulation device according to the present Embodiment, the insulating layer 3 includes the dimples 4 that are located in correspondence with the electrodes 2 respectively and curved concave in the concave direction directed from the front surface 3b of the insulating layer 3 toward the back surface 3a of the insulating layer 3. Each of the electrodes 2 includes a dimple-corresponding portion 5 being curved concave in the concave direction together with one of the dimples 4 that is located in correspondence with the corresponding electrode 2. Thus, liquid L can be stopped efficiently at a desired position on the front surface 3b of the insulating layer 3 due to the dimple 4. The liquid manipulation device can thus have an enhanced ability to control the liquid L, in particular, a droplet L. Since each of the electrodes 2 includes the dimple-corresponding portion 5 as described above, the dimple forming process to form the dimples 4, for example, an embossing process, in which the insulating layer 3, the electrodes 2, and the substrate 1 are together pressed from the front surface 3b of the insulating layer 3, can be performed with a large force to enable deformation of the electrodes 2. As a result, the dimples 4 can be formed into desired shapes easily, whereby improved accuracy with which the liquid manipulation device is processed, can be provided. Thus, improved efficiency for fabricating the liquid manipulation device can be provided.

The front surface 3b of the insulating layer 3 of the liquid manipulation device according to the present Embodiment is open to the outside. Thus, the liquid manipulation device has a simplified configuration on the front surface 3b side of the insulating layer 3, whereby improved efficiency can be provided for fabricating the liquid manipulation device.

In the liquid manipulation device according to the present Embodiment, each of the electrodes 2 is larger than the corresponding one of the dimples 4. Thus, when the dimples 4 are formed in the insulating layer 3 during the dimple forming process, for example, an embossing process, the dimple-corresponding portion 5 of the electrode 2 can be formed to conform to the dimple 4 stably while the perimeter portion 2c of the electrode 2, which is located closer to the outer periphery of the dimple 4 than to the dimple 4, is held. Thus, improved efficiency for fabricating the liquid manipulation device can be provided.

### "Second Embodiment"

A liquid manipulation device according to a Second Embodiment is described below. The liquid manipulation device according to the present Embodiment is similar to the liquid manipulation device according to the First Embodiment except for the substrate. Constituent elements of the present Embodiment that are similar to those of the First Embodiment, are designated with the same reference signs as those of the First Embodiment.

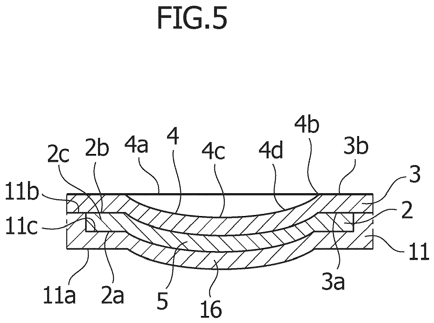

As shown in Fig. 5, the liquid manipulation device according to the present Embodiment includes a substrate 11 that is similar to the substrate 1 of the First Embodiment, except for what is described below. The substrate 11 includes a back surface 11a, a front surface 11b, and a concave portion 11c that correspond to the back surface 1a, the front surface 1b, and the concave portion 1c of the substrate 1 of the First Embodiment, respectively. The substrate 11 includes second dimple-corresponding portions 16 that correspond to the second dimple-corresponding portions 6 of the First Embodiment.

Each of the dimple-corresponding portions 16 of the substrate 11 is curved concave in the concave direction together with the dimple-corresponding portion 5 of one of the electrodes 2 and one of the dimples 4 of the insulating layer 3, the one of the electrodes 2 located in correspondence with the corresponding dimple-corresponding portion 16, the one of the dimples 4 located in correspondence with the corresponding dimple-corresponding portion 16. The second dimple-corresponding portion 16 is located within the concave portion 1c. The back surface 11a of the substrate 11 has portions that are convex at locations at which the second dimple-corresponding portions 16 are located, respectively. The thickness of the substrate 11 is set to allow plastic deformation of the substrate 11 together with the electrodes 2 and the insulating layer 3 during the dimple forming process.

Manipulation to move a droplet L in the liquid manipulation device according to the present Embodiment, is similar to the manipulation to move the droplet L in the First Embodiment. A method of forming the dimples 4 in the present Embodiment, while not specifically shown in a drawing, is similar to the method of forming the dimples in the First Embodiment, except that the lower mold has a contact surface including concave portions being respectively concave in correspondence with the second dimple-corresponding portions that are convex as described above.

In addition to operation and effects similar to those of the liquid manipulation device according to the First Embodiment, the liquid manipulation device according to the present Embodiment can provide operation and effects as described below. In the liquid manipulation device according to the present Embodiment, the substrate 11 includes the dimple-corresponding portions 16 located in correspondence with the dimples 4 respectively. Each of the dimple-corresponding portions 16 of the substrate 11 is curved concave in the concave direction together with the dimple-corresponding portion 5 of one of the electrodes 2 and one of the dimples 4 of the insulating layer 3, the one of the electrodes 2 being located in correspondence with the corresponding dimple-corresponding portion 16, the one of the dimples 4 being located in correspondence with the corresponding dimple-corresponding portion 16.

Thus, the dimple forming process to form the dimples 4, for example, an embossing process, in which the insulating layer 2, the electrodes 2, and the substrate 11 are together pressed from the front surface 3b of the insulating layer 3, can be performed with an even greater force to enable deformation of the substrate 11 in addition to the electrodes 2. As a result, the dimples 4 can be formed into desired shapes easily, whereby improved accuracy with which the liquid manipulation device is processed, can be provided. Thus, improved efficiency for fabricating the liquid manipulation device, can be offered.

While some Embodiments of the present invention have been described above, the present invention is not limited to the aforementioned Embodiments and can be modified or changed based on the technical concept of the present invention.

### [Industrial Applicability]

In use, the liquid manipulation device according to the present invention can be integrated in a device, such as a portable and disposable automated batch-type device, an assay device, and/or the like. Nonlimiting examples of such devices include: a reagent component sensor; a reagent formulation processing device; an automated reagent component selector; a closed microenvironment type isolated aseptic cell incubator; a synthesizer of artificial organs arranged per cell strain; and/or the like.

### [Reference Signs List]

1, 11 ... Substrate, 1b, 11b ... Front surface, 2 ... Electrode, 3 ... Insulating layer, 3a ... Back surface, 3b ... Front surface, 4 ... Dimple, 5 ... First dimple-corresponding portion, 16 ... Second dimple-corresponding portion

## Claims

1. A liquid manipulation device comprising:
a substrate including a sheet shape or a film shape to have flexibility;
a plurality of electrodes located on a front surface of the substrate; and
an insulating layer located over the front surface of the substrate to cover the electrodes, wherein
the insulating layer has: a back surface facing the front surface of the substrate; and a front surface being located opposite the back surface of the insulating layer with respect to a thickness direction of the insulating layer,
the liquid manipulation device is configured to move liquid on the front surface of the insulating layer by using an electrostatic force that is generated when voltage is applied to at least one of the electrodes,
the insulating layer includes dimples that are located in correspondence with the electrodes respectively and are curved concave in a concave direction directed from the front surface of the insulating layer toward the back surface of the insulating layer, and
each of the electrodes includes a dimple-corresponding portion being curved concave in the concave direction together with one of the dimples that is located in correspondence with the corresponding electrode.

2. The liquid manipulation device as claimed in claim 1, wherein
the front surface of the insulating layer is open to outside.

3. The liquid manipulation device as claimed in claim 1, wherein
each of the electrodes is larger than the corresponding one of the dimples.

4. The liquid manipulation device as claimed in claim 1, wherein
the substrate includes dimple-corresponding portions located in correspondence with the dimples respectively, and
each of the dimple-corresponding portions in the substrate is curved concave in the concave direction together with the dimple-corresponding portion in one of the electrodes and one of the dimples in the insulating layer, the one of the electrodes being located in correspondence with the corresponding dimple-corresponding portion in the substrate, the one of the dimples in the insulating layer being located in correspondence with the corresponding dimple-corresponding portion in the substrate.
